# EUROPÄISCHE PATENTSCHRIFT

(11) **EP 3 005 431 B1**
(45) Veröffentlichungstag und Bekanntmachung des Hinweises auf die Patenterteilung: **19.06.2019**
(21) Anmeldenummer: 14730434.9
(22) Anmeldetag: 07.05.2014
(51) Int. Cl.: H01L 41/04, F16K 31/00, H01L 41/09, H02N 2/02, H02N 2/04

(54) **PIEZOELEKTRISCHER AKTOR**
PIEZOELECTRIC ACTUATOR
ACTIONNEUR PIÉZOÉLECTRIQUE

(30) Priorität: 29.05.2013 DE 102013105557
(43) Veröffentlichungstag der Anmeldung: 13.04.2016
(73) Patentinhaber: Förg, Michael, 85354 Freising-Sünzhausen (DE); Lachner, Hubert, 85354 Freising-Hohenbachern (DE)
(72) Erfinder: Förg, Michael, 85354 Freising-Sünzhausen (DE); Lachner, Hubert, 85354 Freising-Hohenbachern (DE)
(74) Vertreter: Kuhnen & Wacker Patent- und Rechtsanwaltsbüro PartG mbB
(86) Internationale Anmeldenummer: PCT/EP2014/059287
(87) Internationale Veröffentlichungsnummer: WO 2014/191172

(56) Entgegenhaltungen:
- DE-A1- 19 961 736
- JP-A- H07 213 997
- JP-A- 2011 185 399
- US-A1- 2011 002 485

## Beschreibung

Die Erfindung betrifft einen piezoelektrischen Aktor mit einseitig angeordneten Elektroden und zumindest einem Aufsatzelement, sowie die Anwendung dieses piezoelektrischen Aktors in einem Mikro-Ventil. So dient der erfindungsgemäße piezoelektrische Aktor als mikromechanisches Stellelement.

Piezoelektrische Aktoren wandeln elektrische Energie in mechanische Energie um und ermöglichen kleinste Bewegungen bei geringer Ansprechzeit. Herkömmliche piezoelektrische Aktoren weisen die Form einer Scheibe oder einer Platte mit einer definierten Dicke auf. Dabei besteht die Scheibe oder Platte aus einem piezoelektrisch vorteilhaften Material, wie zum Beispiel polykristalline ferroelektrische Keramiken (beispielsweise Barium Titanat oder Blei-Zirkon-Titanat (PZT)). PZT-Piezokeramik ist in vielen Varianten verfügbar und eine häufig verwendete Keramik für Aktoranwendungen. Weiter befinden sich jeweils auf beiden gegenüberliegenden Seiten der Scheibe oder Platte Elektroden, welche bei Erregung ein elektrisches Feld aufbauen, das in Dickenrichtung der Scheibe oder Platte orientiert ist. Dieses elektrische Feld in dem piezoelektrischen Material führt zu einer Längenänderung bzw. Dehnung des Materials.

Dabei wird der hinlänglich bekannte inverse piezoelektrische Effekt genutzt, bei dem elektrische Felder piezoelektrische Materialien verformen. Die Dehnung der Piezokeramik ist unter anderem abhängig von der elektrischen Feldstärke zwischen den Elektroden, der Länge des Materials zwischen den Elektroden und den piezoelektrischen Materialeigenschaften. Die in der Praxis häufig eingesetzten Aktoren erreichen relative Auslenkungen von maximal 1/1000 der Dicke des Materials. Für eine größere maximale Längenänderung benötigt man entsprechend deutlich mehr Materialdicke. Weiter sind relativ hohe Feldstärken im Bereich von mehreren tausend V/mm erforderlich, um vorstehend genanntes Verhältnis von 1/1000 zu erreichen. Auch werden oft mehrere piezoelektrische Aktoren aufeinander gestapelt, um eine höhere Auslenkung zu erreichen.

Weiter sind piezoelektrische Biegeaktoren bzw. Uni-/Bimorphaktoren bekannt, die in Scheibenbauform als so genannte Disk-Translatoren ausgeführt sind, bei denen sich bei Erregung das Zentrum der Scheibe wölbt. So befinden sich auch bei dieser Art von Aktoren die Elektroden auf beiden Seiten des piezoelektrischen Materials.

Dabei kann ein derartiger Aufbau mit Elektroden auf beiden Seiten für einige mikrotechnische Anwendungen nicht erwünscht sein. So führt dies zu einem erhöhten Platzbedarf, sowie zu hohen Anforderungen bei der elektrotechnischen Auslegung, beispielsweise in Bezug auf Überschlags-/Spannungsfestigkeit oder der Leistungsfähigkeit der Elektrodenansteuerung. Beispielsweise muss man den Aktor entsprechend beidseitig isolieren.

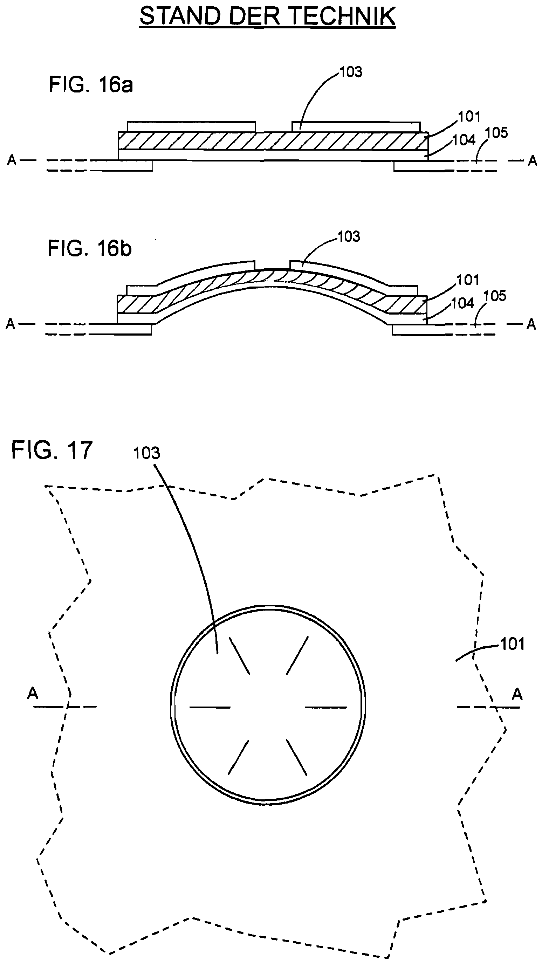

Die DE 10 2009 002 631 A1 offenbart einen piezoelektrischen Aktor, bei dem beide Elektroden einseitig auf dem piezoelektrischen Material angeordnet sind, sowie ein Mikro-Ventil, das mit Hilfe des Aktors aufgebaut ist. So wird bei der DE 10 2009 002 631 A1 der inverse piezoelektrische Effekt über die gesamte Breite des Aktors genutzt, und nicht, wie dies bei herkömmlichen Aktoren der Fall ist, über dessen Dicke. Die Figuren 16a und 16b zeigen einen Querschnitt dieses piezoelektrischen Aktors. In Figur 16a befindet sich der Aktor im Ruhezustand. Dieser besteht aus der piezoelektrischen Schicht 101 (das Piezoelement), der Membran 104 bzw. der Verformungsschicht 104 und den Elektroden 103, welche eine abwechselnde Polarität aufweisen, und weiter ist dieser an den Seiten der Unterseite der piezoelektrischen Schicht 101 auf einer Membranauflage 105 befestigt. Dabei ist die piezoelektrische Schicht 101 relativ dünn, beispielsweise ein paar hundert µm, und ist einige mm breit, beispielsweise 10 bis 50 mm. Figur 16b zeigt den erregten Aktor, wenn die Elektroden 103 erregt werden. In Folge bilden sich in der piezoelektrischen Schicht 101 elektrische Felder, und damit dehnt sich die piezoelektrische Schicht 101 aus. Die höchsten Feldstärken treten in der elektrodenseitigen Oberfläche der piezoelektrischen Schicht 101 auf, während diese in Richtung des Inneren der piezoelektrischen Schicht 101 abnehmen. Auch ist die Membran 104 piezoelektrisch neutral, d.h. deren Länge bleibt von dem elektrischen Feld weitgehend unbeeinflusst. Aufgrund der vorstehend beschriebenen Inhomogenität des elektrischen Feldes dehnt sich die piezoelektrische Schicht 101 auf deren Elektrodenseite mehr aus, als in deren Inneren oder auf deren der Elektrodenseite gegenüberliegenden Seite. Im Endeffekt wölbt sich der Aktor, wie in Fig. 16b gezeigt, um eine gewisse Auslenkung nach oben.

Eine detaillierte Erläuterung der Hintergründe der DE 10 2009 002 631 A1 findet sich auch in: "S. Zähringer, N. Schwesinger; What Happens Turning a 250µm Thin Piezo-stack Sideways? An experimental and analytical approach to one-side-actuated piezoelectric micro drives, regarding electrode layouts and directions of deflection, DTIP of MEMS and MOEMS, Rom 2009, Seiten 394 - 397".

Figur 17 zeigt zur Veranschaulichung des Stands der Technik eine Aufsicht des Aktors der DE 10 2009 002 631 mit den Elektroden 103. Die sternförmige Elektrodenstruktur führt zu einer radialsymetrischen Dehnung der piezoelektrischen Schicht 101. So bildet dieser Aktor bei Erregung der Elektroden 103 eine Auswölbung in Form eines Hügels bzw. einer Konkavität.

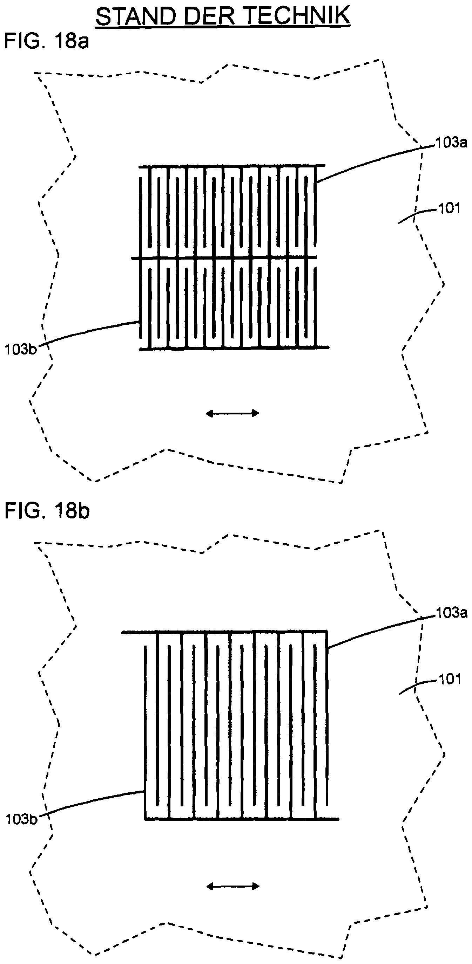

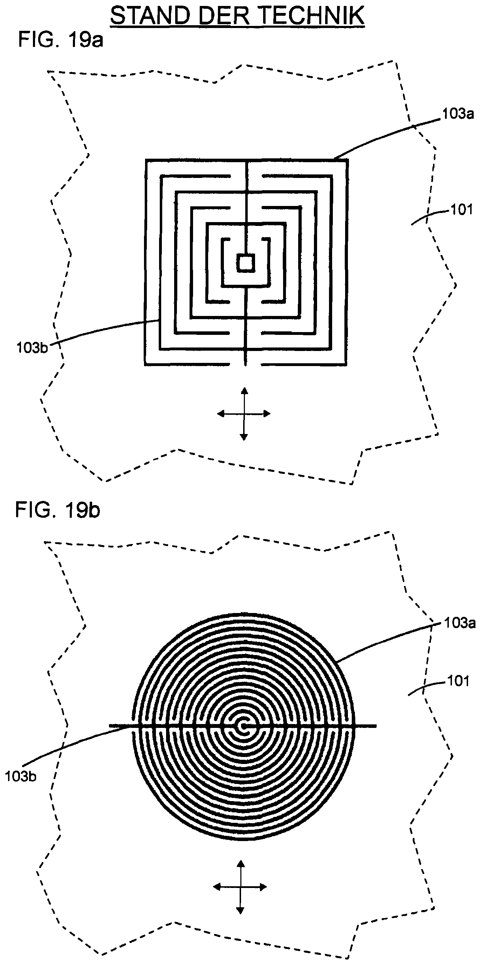

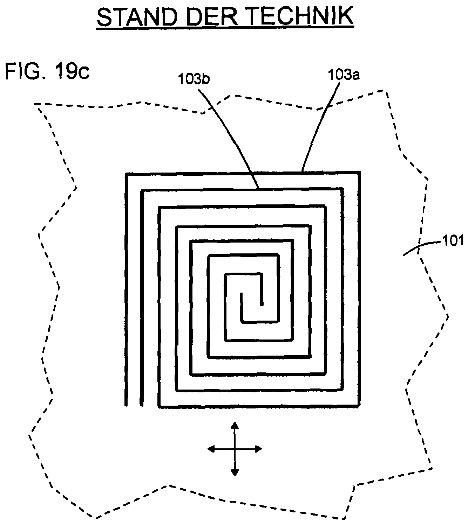

Die Figuren 18a und b, sowie 19a, b, und c der vorstehend genannten Publikation zeigen eine Aufsicht von Varianten der Elektrodenstruktur mit einer ersten Elektrode 103a und einer zweiten Elektrode 103b. So führen verschiedene Geometrien der Elektroden zu unterschiedlichen Dehnungsrichtungen der piezoelektrischen Schicht 101 und unterschiedlichen Richtungen und Höhen der Auslenkungen. In den Figuren 18a und 18b führt die Vorzugsrichtung des elektrischen Feldes zu eine Ausdehnung der piezoelektrischen Schicht 101, wie durch den Doppelpfeil angedeutet, während bei den Fällen der Elektrodenstruktur der Figuren 19a, und c die Ausdehnung der piezoelektrischen Schicht 101 überwiegend in die durch den jeweiligen Pfeil angedeuteten Richtungen erfolgt, und bei dem Fall der Elektrodenstruktur der Figur 19b die Ausdehnung annähernd radialsymetrisch erfolgt. Allerdings kommt es durch Streufelder und Kanteneffekte auch zu geringfügigen Dehnungen in andere Richtungen. Zur Veranschaulichung werden die jeweiligen Vorzugs-Dehnungsrichtungen in den Figuren durch Pfeile angegeben.

Entscheidend für die Wirkungsweise des Aktors ist nun die Höhe und Reproduzierbarkeit der Auslenkung bzw. des Hubs. So weist der piezoelektrische Aktor der DE 10 2009 002 631 A1 die Nachteile auf, dass dessen Auslenkung für einige Anwendungen nicht ausreichend oder falsch orientiert ist oder bei verschiedenen Aktoren gleicher Bauweise unterschiedlich sein kann.

Beispielsweise zeigt die sternförmige Elektrodenstruktur eine Auslenkung, welche bei Erregung generell nach unten erfolgt, wobei jedoch ein Abschnitt in der Mitte der Elektrodenstruktur auch eine Auslenkung nach oben aufweist.

Weiter kann eine Abhängigkeit der Auslenkung dieses Aktors von der Beschaffenheit der piezoelektrischen Schicht 101 und von der Beschaffenheit der Elektrodenstruktur bestehen. Dabei kann auch die Auslenkung von verschiedenen Aktoren gleicher Bauweise unterschiedlich zueinander sein, da bei der Herstellung der piezoelektrischen Schicht 101 und der Elektrodenstruktur Fertigungstoleranzen auftreten können. So besteht ein Problem dieser Aktoren darin, dass diese untereinander unterschiedliche Arbeitscharakteristika aufweisen oder beispielsweise eine Herstellungscharge Aktoren mit einer deutlich geringeren Auslenkung aufweisen kann. Ein herkömmlicher Lösungsansatz für dieses Problem, beispielsweise ein positionsgeregelter Betrieb des Aktors mit Hilfe eines Controllers, der eine Regelungschleife beinhaltet, ist mit einem hohen Aufwand verbunden.

Weiter beeinflusst auch die Form der piezoelektrischen Schicht 101 die Auslenkung. So weist beispielsweise ein viereckiger Aktor eine andere Auslenkung auf wie ein runder Aktor, bei ansonsten gleichen Randbedingungen (Ansteuerspannung, Elektrodenstruktur, etc.) und gleichen Maximalabmessungen. Nun ist es aber für bestimmte Anwendungen erforderlich, dass die Auslenkung verschiedener Aktoren unabhängig von ihrer Form annähernd identisch ist.

Weiterer relevanter Stand der Technik ist in den Druckschriften JP 2011-185399 A, JP 7-213997 A, US 2011/0002485 A1 und DE 199 61 736 A1 beschrieben.

So ist es in Anbetracht der vorstehend erläuterten Probleme die der Erfindung zugrundeliegende Aufgabe, einen piezoelektrischen Aktor mit einer optimierten Auslenkung anzugeben. Eine weitere Aufgabe der vorliegenden Erfindung besteht darin, einen piezoelektrischen Aktor anzugeben, der eine bessere Reproduzierbarkeit dieser Auslenkung aufweist. Zudem ist es eine Teilaufgabe der Erfindung einen piezoelektrischen Aktor anzugeben, der eine größere Unabhängigkeit von der Form des Aktors aufweist.

Die der Erfindung zugrunde liegende Aufgabe wird durch einen piezoelektrischen Aktor gemäß Anspruch 1 gelöst. Vorteilhafte Weiterentwicklungen und Ausführungsformen sind Gegenstand der weiteren nebengeordneten und abhängigen Ansprüche.

Insbesondere ist auf dem Piezoelement ein Aufsatzelement angebracht. Das Aufsatzelement schafft durch eine Umfassung der Elektrodenstruktur eine räumliche Begrenzung für die Ausdehnung des Piezoelements. So weist das Aufsatzelement eine Innenkavität bzw. eine Aussparung auf, der bzw. die einen umfassten Bereich definiert. Dadurch, dass die Ausdehnung des Piezoelements auf die umfasste Fläche beschränkt wird, vergrößern sich die Auslenkung des Aktors bzw. der Wirkungsgrad des Aktors. So konzentriert sich die Ausdehnung auf den umfassten Bereich. Weiter weist ein Piezoelement mit einer sternförmigen Elektrodenstruktur mit dem erfindungsgemäßen Aufsatzelement nunmehr eine Auslenkung ausschließlich in Richtung der Seite der Elektrodenstruktur auf. Auch wird die Auslenkung weitestgehend unabhängig von der tatsächlichen Außenform des Piezoelements und den Fertigungstoleranzen, die die Kräfteverteilung in dem Piezoelement negativ beeinflussen könnten.

Weiter ist das Aufsatzelement auf der Oberfläche des Piezoelements auf der gleichen Seite wie die Elektrodenstruktur platziert, da dies der Ort der stärksten Verformung ist, und eben dort das Aufsatzelement die Kräfte unmittelbar aufnehmen kann.

Bei einem Aktor gemäß der Erfindung kann die zumindest teilweise umfasste Fläche des Piezoelements vollständig oder nahezu vollständig von der Elektrodenstruktur bedeckt sein. Je größer die Fläche der Elektrodenstruktur, umso größer ist das Volumen des Piezoelements, das für den inversen Piezoeffekt genutzt wird, und um so größer ist die erzielbare Ausdehnung des Piezoelements. Somit optimiert dieses Merkmal die Flächennutzung des Piezoelements und auch die Auslenkung des Piezoelements.

Nach einem Teilaspekt der Offenbarung steht das Aufsatzelement ausschließlich in Kontakt mit dem Piezoelement.

Nach einem nicht beanspruchten Teilaspekt der Offenbarung ist das Aufsatzelement an die einseitig angebrachte Elektrodenstruktur des piezoelektrischen Aktors derart angepasst, dass das Aufsatzelement eine Ausdehnung in der Ebene des Piezoelements in die Richtungen weitgehend begrenzt, in die sich das Piezoelement aufgrund der Konfiguration der Elektrodenstruktur überwiegend ausdehnt. Verschiedene Konfigurationen der Elektrodenstruktur resultieren in unterschiedlichen Vorzugsrichtungen der Ausdehnung des Aktors. So ist es nicht notwendig, das Aufsatzelement so zu gestalten, dass dieses die Ausdehnung des Piezoelements in alle Richtungen gleich begrenzt, d.h., das Aufsatzelement kann auch nur teilweise umfassend oder teilweise verstärkt ausgeführt sein. Damit kann das Aufsatzelement einfacher und/oder zielgerichteter gestaltet sein.

Nach einem nicht beanspruchten Teilaspekt der Offenbarung kann sich die Elektrodenstruktur teilweise unter dem Aufsatzelement befinden.

Nach einem nicht beanspruchten Teilaspekt der Offenbarung kann eine flächenmäßige Unter- oder Überdeckung der Fläche der Elektrodenstruktur mit der von dem Aufsatzelement umfassten Fläche vorliegen.

Nach einem nicht beanspruchten Teilaspekt der Offenbarung kann das Aufsatzelement Aussparungen oder Lücken aufweisen. Diese können beispielsweise für Kontaktierungen der Elektrodenstruktur an Stellen vorgesehen sein, die für die Funktion oder Steifigkeit des Aufsatzelements nicht maßgeblich sind.

Nach einer Weiterbildung der Erfindung kann das Material des Piezoelements eine Keramik aus Blei-Zirkonat-Titanat (PZT) sein. PZT Piezokeramik ist in vielen Variationen verfügbar und die am häufigsten verwendete Keramik für piezoelektrische Aktoranwendungen. Dabei weist PZT eine ausreichende Eigensteifigkeit auf, auch wenn die Elektrode nicht erregt ist.

Nach einem nicht beanspruchten Teilaspekt der Offenbarung kann das Aufsatzelement aus einem Material mit einem hohen Elastizitätsmodul ausgebildet sein. Das Aufsatzelement erfüllt seine vorstehend beschriebene Funktion umso besser, je mehr Widerstand es seiner Verformung entgegensetzt, d.h., je höher sein Elastizitätsmodul ist. Ein für die Anwendung ausreichend hohes Elastizitätsmodul beginnt bei etwa 1 kN/mm². Diese Anforderung wird von einigen Kunststoffarten und Metallen erfüllt.

Nach einem nicht beanspruchten Teilaspekt der Offenbarung kann das Aufsatzelement aus einem Material mit einer hohen Leitfähigkeit ausgebildet und geerdet sein. Allerdings darf in diesem Fall das Aufsatzelement nicht mit den Elektroden in Kontakt stehen bzw. in Berührung kommen. An den Elektroden der Elektrodenstruktur liegen relativ hohe Spannungen an. Nachdem die Elektrodenstruktur zumindest teilweise von dem Aufsatzelement umfasst ist, kann ein leitfähiges Aufsatzelement, beispielsweise aus Metall, welches geerdet ist, als Erdungsschutz oder auch als neutraler Pol der Elektroden dienen.

Gemäß einem weiteren nicht beanspruchten Teilaspekt der Offenbarung wird ein Mikro-Ventil vorgeschlagen, dass den vorstehend geschriebenen Aktor mit zumindest einem Einlasskanal und zumindest einem Auslasskanal aufweist. Damit kann ein Mikro-Ventil geschaffen werden, das im nicht-erregten Zustand geschlossen ist, da das Piezoelement im ersteren Zustand steif und eben verbleibt, und im erregten Zustand geöffnet ist.

Die vorstehend beschriebenen Merkmale und Funktionen der vorliegenden Erfindung sowie weitere Aspekte und Merkmale werden nachfolgend anhand einer detaillierten Beschreibung von bevorzugten Ausführungsformen unter Bezugnahme auf die beigefügten Figuren weiter beschrieben.

### KURZE BESCHREIBUNG DER ZEICHNUNGEN

Hierbei zeigt:
- Fig. 1: einen Querschnitt eines piezoelektrischen Aktors einer ersten Ausführungsform der vorliegenden Erfindung;
- Fig. 2: eine Draufsicht auf den piezoelektrischen Aktor der ersten Ausführungsform der vorliegenden Erfindung;
- Fig. 3: einen Querschnitt eines piezoelektrischen Aktors einer zweiten Ausführungsform der vorliegenden Erfindung;
- Fig. 4: einen Querschnitt eines piezoelektrischen Aktors einer dritten Ausführungsform außerhalb der vorliegenden Erfindung;
- Fig. 5: einen Querschnitt eines piezoelektrischen Aktors einer vierten Ausführungsform der vorliegenden Erfindung;
- Fig. 6: einen Querschnitt eines piezoelektrischen Aktors einer fünften Ausführungsform der vorliegenden Erfindung;
- Fig. 7: eine Draufsicht auf einen piezoelektrischen Aktor einer sechsten Ausführungsform der vorliegenden Erfindung;
- Fig. 8: eine Draufsicht auf einen piezoelektrischen Aktor einer siebten Ausführungsform der vorliegenden Erfindung;
- Fig. 9: eine Draufsicht auf einen piezoelektrischen Aktor einer achten Ausführungsform der vorliegenden Erfindung;
- Fig. 10: eine Draufsicht auf einen piezoelektrischen Aktor einer neunten Ausführungsform der vorliegenden Erfindung;
- Fig. 11: eine Draufsicht auf einen piezoelektrischen Aktor einer zehnten Ausführungsform der vorliegenden Erfindung;
- Fig. 12: eine Draufsicht auf einen piezoelektrischen Aktor einer 11. Ausführungsform der vorliegenden Erfindung;
- Fig. 13: eine Draufsicht auf einen piezoelektrischen Aktor einer 12. Ausführungsform der vorliegenden Erfindung;
- Fig. 14: eine Draufsicht auf einen piezoelektrischen Aktor einer 13. Ausführungsform der vorliegenden Erfindung;
- Fig. 15a: einen vertikalen Querschnitt eines Mikro-Ventils, das mit einem piezoelektrischen Aktor einer beliebigen Ausführungsform der vorliegenden Erfindung aufgebaut ist, welches geschlossen ist;
- Fig. 15b: einen Querschnitt eines Mikro-Ventils, das mit einem piezoelektrischen Aktor einer beliebigen Ausführungsform der vorliegenden Erfindung aufgebaut ist, welches geöffnet ist;
- Fig. 16a: einen Querschnitt eines Aktors des Stands der Technik, dessen Elektroden nicht erregt sind.
- Fig. 16b: einen Querschnitt eines Aktors des Stands der Technik, dessen Elektroden erregt sind.
- Fig. 17: eine Draufsicht auf einen piezoelektrischen Aktor des Stands der Technik;
- Fig. 18a, b: eine Draufsicht auf einen piezoelektrischen Aktor des Stands der Technik mit Varianten einer Elektrodenstruktur mit einer ersten Elektrode und einer zweiten Elektrode;
- Fig. 19a, b, c: eine Draufsicht auf einen piezoelektrischen Aktor des Stands der Technik mit Varianten einer Elektrodenstruktur mit einer ersten Elektrode und einer zweiten Elektrode.

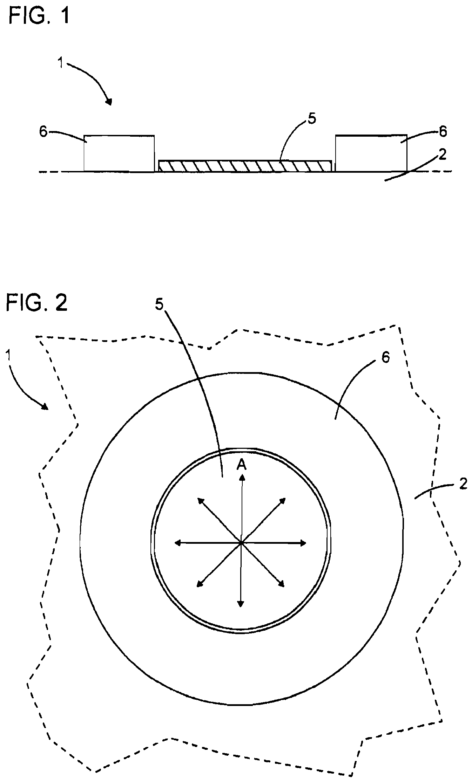

Fig. 1 zeigt einen Querschnitt des und Fig. 2 eine Draufsicht auf den erfindungsgemäßen piezoelektrischen Aktor 1 einer ersten Ausführungsform.

Das Piezoelement 2 des piezoelektrischen Aktors 1 ist in Form einer flachen Scheibe oder Platte ausgeführt. Das Material des Piezoelements ist ein Material mit hohen piezoelektrischen Koeffizienten, vorzugsweise Blei-Zirkonat-Titanat (PZT) in Form einer Keramik. Alternativ können auch andere Ferroelektrika, wie beispielsweise Barium-Titanat, zum Einsatz kommen. Zudem kämen auch Materialien wie Quarz oder Blei-Magnesium-Niobat in Frage. Weiter kann die Außenform des Piezoelements 2 beliebig an die Anwendung, beispielsweise an die vorhandene Auflagefläche, angepasst werden. So kann diese Form beispielsweise rund, quadratisch, viereckig, oval oder auch ein Polygon mit einer beliebigen Anzahl von Kanten sein. Diese beliebige Form ist in Fig. 2 durch die gestrichelte Rahmenlinie angedeutet.

Auf einer Seite bzw. auf einer der ebenen Oberflächen des Piezoelements 2 befindet sich eine Elektrodenstruktur 5 mit üblicherweise zwei Elektroden. Diese Seite wird im Folgenden auch als Oberseite bezeichnet. Die der Oberseite abgewandte Seite wird im Folgenden als Unterseite bezeichnet. Weiter ist auch eine Konfiguration mit drei oder mehr Elektroden denkbar, wobei diese Elektroden beispielsweise dann jeweils getrennt erregt werden können. Die Elektroden sind als Oberflächenelektroden ausgebildet, welche beispielsweise aufgesputtert oder mit einem Bedampfungs-Verfahren auf das Piezoelement aufgebracht werden. Beispiele für derartige Elektrodenstrukturen finden sich in den Figuren 18a, b und 19a, b, c. Weiter ist die Elektrodenstruktur 5 vorzugsweise sternförmig ausgebildet. Dabei befindet sich die Elektrodenstruktur 5 einseitig auf dem Piezoelement, d.h. nur auf einer Seite des Piezoelements und nimmt auf diesem eine definierte Fläche ein. Diese Fläche der Elektrodenstruktur 5 ist die Oberfläche, die von den Elektroden der Elektrodenstruktur 5 und den Zwischenräumen zwischen den Elektroden beansprucht wird. In anderen Worten wird die (Gesamt-) Fläche der Elektrodenstruktur 5 durch deren Außenkontur bestimmt (vgl. Umriss in Fig. 2). Der piezoelektrische Aktor 1 kann fixiert sein, beispielsweise an seiner Unterseite.

Wird nun eine Spannung an die Elektrodenstruktur 5 angelegt, so entsteht ein inhomogenes elektrisches Feld zwischen den einzelnen Elektroden. Dabei sind die elektrischen Feldstärken in der Nähe der Elektroden und in der Oberfläche des Piezoelements 2 am größten, während die Feldstärken von der Oberfläche des Piezoelements 2 in Richtung des Inneren des Piezoelements 2 hin abnehmen. So dehnt sich das Piezoelement 2 flächenhaft auf der Seite der Elektrodenstruktur 5 mehr als auf seiner Unterseite aus, was zu einer Krümmung des Piezoelements 2 führt.

Weiter ist auf dem Piezoelement 2 ein Aufsatzelement 6 angebracht, welches die Elektrodenstruktur 5 umfasst. Das Aufsatzelement 6 schafft damit eine räumliche Begrenzung für die Ausdehnung des Piezoelements 2 nach außen (vgl. Pfeile A in Fig. 2), womit sich die Ausdehnung des Piezoelements 2 nicht weiter in die Radialrichtungen (in der Ebene) des Piezoelements 2 über die Begrenzung hinaus, sondern im Wesentlichen nur noch senkrecht zur Ebene des Piezoelements 2 entfalten kann.

Zudem ist das Aufsatzelement 6 auf der gleichen Seite wie die Elektrodenstruktur 5 auf der Oberfläche des Piezoelements 2 platziert, da dies der Ort der stärksten Verformung ist. So kann das Aufsatzelement 6 die Kräfte, welche aus der Verformung des Piezoelements 2 resultieren, direkt und unmittelbar aufnehmen.

Das Aufsatzelement 6, welches beispielsweise aus einem Kunststoff oder Metall mit einem hohen Elastizitätsmodul besteht, ist relativ einfach mit einer hohen Maßhaltigkeit herstellbar, während eine maßgenaue Bearbeitung des relativ dünnen und spröden Piezoelements 2 des Aktors 1 ein aufwändiger Vorgang ist. So vereinfacht das Aufsatzelement 6 die Herstellung des Aktors 1.

Das Aufsatzelement 6 soll nun einen möglichst großen Widerstand gegen elastische Verformung aufgrund angreifender Kräfte aufweisen. Es spielen die Querschnittsfläche und die Form des Querschnitts eine wesentliche Rolle bei der Festlegung der Form des Aufsatzelements 6.

Idealerweise stimmt die Innenkontur des Aufsatzelements 6, welche die umfasste Fläche des Aufsatzelements 6 definiert, mit der Fläche der Elektrodenstruktur 5 überein. Das heißt, dass die optimale Auslenkung des Aktors 1 in dem Fall erreicht wird, in dem die umfasste Fläche des Aufsatzelements 6 mit der Fläche der Elektrodenstruktur 5 übereinstimmt.

Alternativ kann eine flächenmäßige Unter- oder Überdeckung der Elektrodenstruktur 5 mit der umfassten Fläche des Aufsatzelements 6 vorliegen. So wurde experimentell ermittelt, dass bei einer Unter- oder Überdeckung von bis zu 30% immer noch eine geeignete Auslenkung erreicht wird.

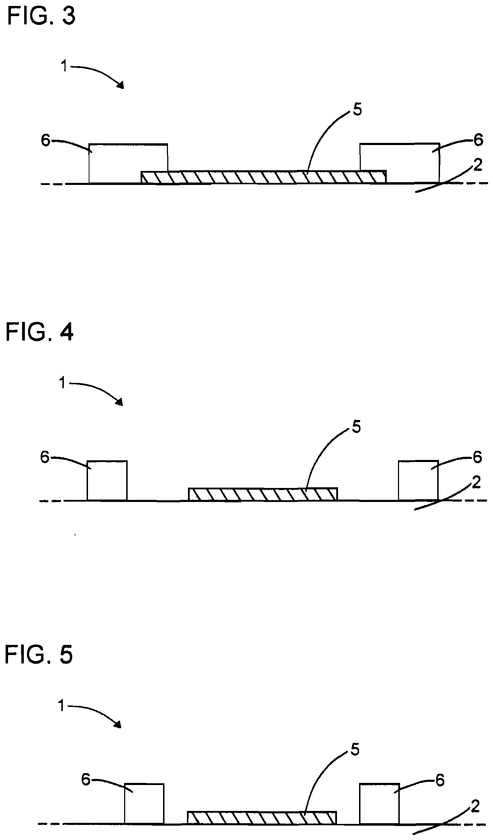

Fig. 3 zeigt einen piezoelektrischen Aktor 1 einer zweiten Ausführungsform außerhalb der vorliegenden Erfindung. Bei dieser ist die Elektrode zumindest teilweise von dem Aufsatzelement 6 überdeckt. So kann die Fläche der Elektrodenstruktur 5 vergrößert werden, ohne die Steifigkeit des Aufsatzelements 6 zu stark zu reduzieren.

Fig. 4 zeigt einen piezoelektrischen Aktor 1 einer dritten Ausführungsform der vorliegenden Erfindung. Es ist grundsätzlich nicht erforderlich, dass die Außenkontur der Elektrodenstruktur 5 unmittelbar an die Innenkontur des Aufsatzelements 6 angrenzt. Die Auslenkung des Piezoelements 2 wird durch die maximale Belastbarkeit bzw. Sprödheit des verwendeten Materials des Piezoelements 2 beschränkt.

Fig. 5 zeigt einen piezoelektrischen Aktor 1 einer vierten Ausführungsform der vorliegenden Erfindung. Dabei ist das Aufsatzelement 6 im Gegensatz zu den Ausführungsformen eins bis drei nicht am Rand des Piezoelements 2, sondern weiter zur Mitte hin befestigt. Dies ist beispielsweise dann sinnvoll, wenn die Abmessungen des Piezoelements 2 sehr groß sind. Alternativ kann die Elektrodenstruktur 5 bei dieser Ausführungsform unmittelbar an das Aufsatzelement 6 heranreichen.

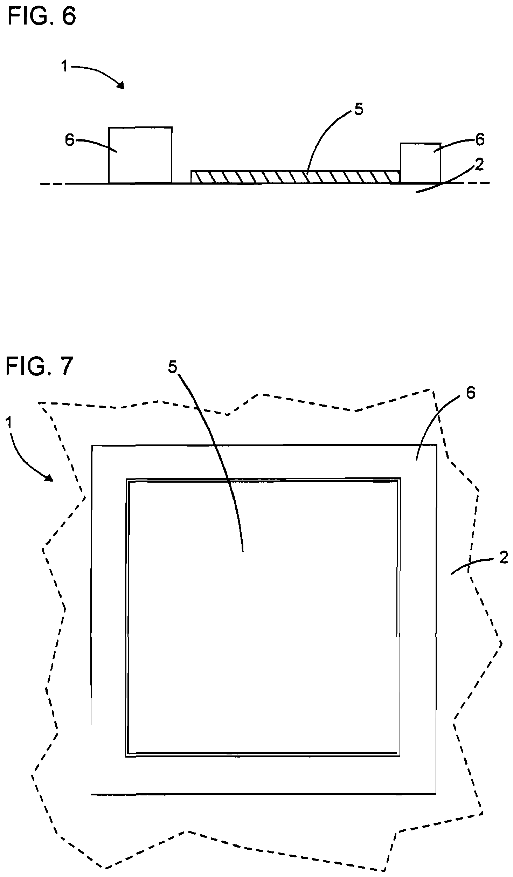

Fig. 6 zeigt einen piezoelektrischen Aktor 1 einer fünften Ausführungsform der vorliegenden Erfindung. Hierbei ist das Aufsatzelement 6 asymmetrisch ausgestaltet. Auch ist die Elektrodenstruktur 5 nicht mittig, sondern seitlich versetzt ausgestaltet. Beide Faktoren können dazu führen, dass eine asymmetrische Auslenkung des Piezoelements erzielt werden kann. So wird das Maximum der Auslenkung nicht mehr in der Mitte des Piezoelements 2 liegen und ebenso wird die Form der Auswölbung asymmetrisch sein. Dies kann beispielsweise dann sinnvoll sein, wenn durch den Aktor 1 der vorliegenden Erfindung optische Systeme, beispielsweise Reflektoren, angesteuert werden.

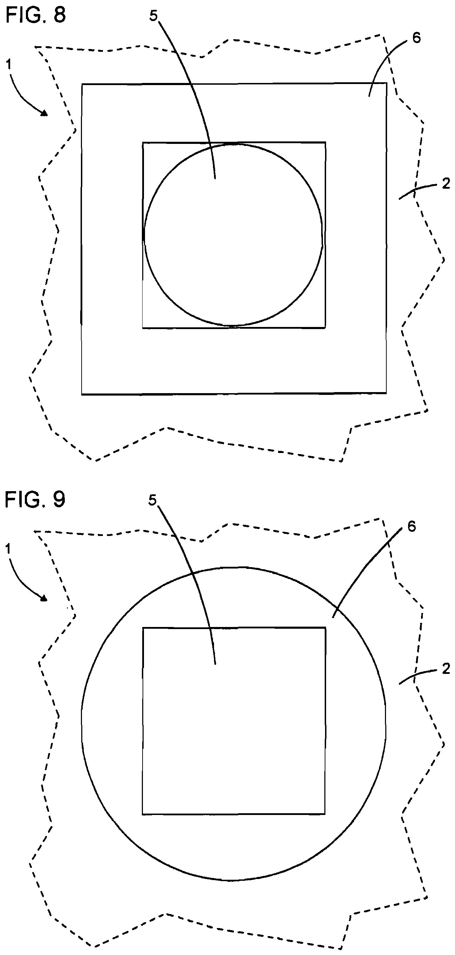

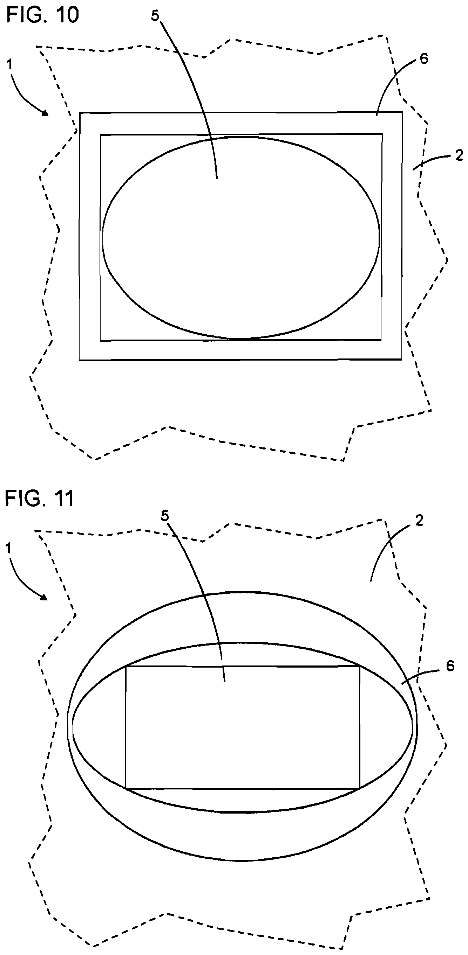

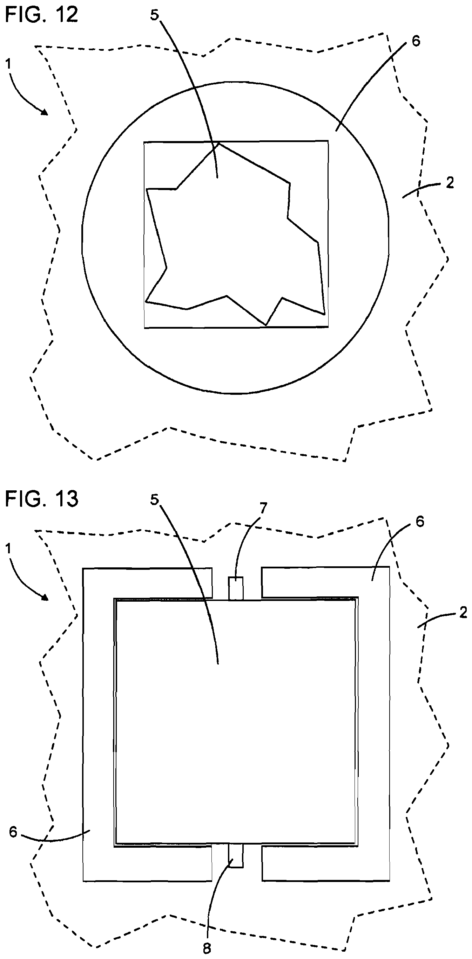

Die Figuren 7 bis 12 zeigen Aufsichten von verschiedenen Geometrien der Elektrodenstruktur 5 und des Aufsatzelements 6 jeweils gemäß einer sechsten bis 11. Ausführungsform. So kann die Außenkontur der Elektrodenstruktur 5 mit der Innenkontur des Aufsatzelements 6 übereinstimmen; dies ist jedoch nicht unbedingt erforderlich. So kann es beispielsweise aus fertigungstechnischen Gründen einfacher sein, eine viereckige Aufsatzstruktur 6 zu verwenden, um eine kreisförmige Elektrodenstruktur 5 zu umschließen. So können die Formen der Elektrodenstruktur 5 und des Aufsatzelements 6 unterschiedlich zueinander sein, solange diese ihren Zweck erfüllen. Dabei kann auch, wie bei der vierten Ausführungsform erläutert, ein Teil der Fläche des Piezoelements 2 ungenutzt verbleiben. Zudem kann, wie in Fig. 12 gezeigt, die Elektrodenstruktur 5 eine unregelmäßige Außenkontur aufweisen. Die Form und Ausbildung der Elektrodenstruktur 5 bestimmt zusammen mit dem Aufsatzelement die Form der Auswölbung des Piezoelements 2. Beispielsweise erzeugt die Elektrodenstruktur 5 der Fig. 19b zusammen mit dem Aufsatzelement 6 der Fig. 8 eine symmetrische, hügelförmige Auswölbung. So können diese Geometrien in einem großen Maße variiert werden, ohne von dem Lösungsprinzip der Erfindung abzuweichen.

Fig. 13 zeigt einen Aktor 1 gemäß einer 12. Ausführungsform mit zwei Aufsatzelementen 6, welche gemeinsam eine Elektrodenstruktur 5 teilweise, vorzugsweise fast vollständig, umfassen. So ist es nicht notwendig, dass nur ein Aufsatzelement 6 verwendet wird. Es können auch mehrere Aufsatzelemente 6, beispielsweise zwei oder drei, eine gemeinsame Umfassung ausbilden. Alternativ kann ein Aufsatzelement 6 segmentiert sein. Die so entstehenden Lücken können beispielsweise für eine erste Kontaktierungsstelle 7 und eine zweite Kontaktierungsstelle 8 zum Anschluss an die Elektroden der Elektrodenstruktur 5 genutzt werden.

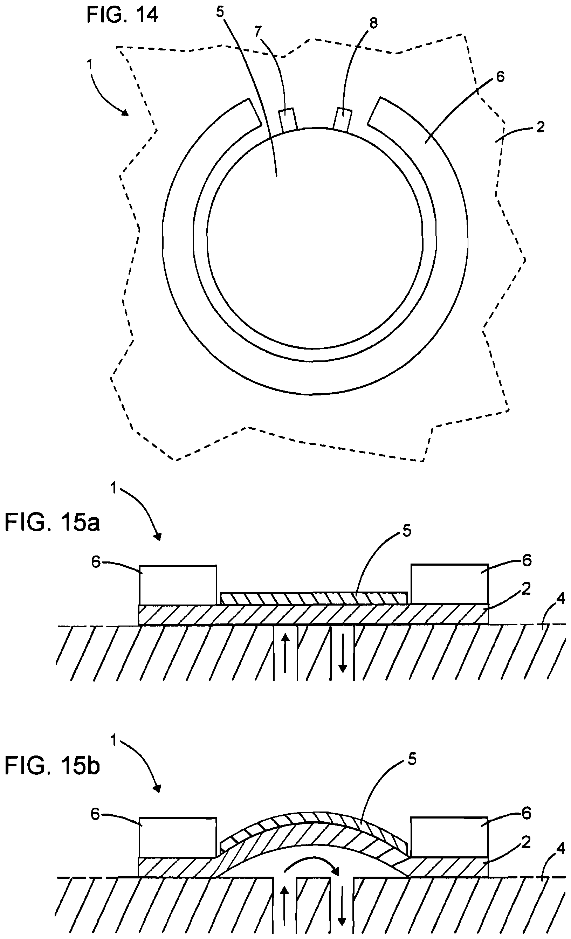

Fig. 14 zeigt einen Aktor 1 gemäß einer 13. Ausführungsform mit einem Aufsatzelement 6, welches eine Elektrodenstruktur 5 nur teilweise umfasst. Die Strukturschwächung durch eine Lücke in dem Aufsatzelement 6, beispielsweise für eine erste Kontaktierungsstelle 7 und eine zweite Kontaktierungsstelle 8 zum Anschluss an die Elektroden der Elektrodenstruktur 5, kann unter Umständen vernachlässigt werden. Voraussetzung dafür ist beispielsweise, dass das verwendete Material des Aufsatzelements 6 eine hohe Steifigkeit aufweist und/oder die Lücke klein genug ist.

Die Figuren 15a und 15b zeigen die beispielhafte Verwendung des piezoelektrischen Aktors der vorliegenden Erfindung als Mikro-Ventil. Dabei weist eine Auflage 4 bzw. ein Ventilsitz 4 des Aktors 1 zwei Durchlässe auf, welche zumindest einen Einlasskanal und zumindest einen Auslasskanal für eine Flüssigkeit oder ein Gas ausbilden. Fig. 15a stellt den Zustand dar, bei dem das Mikro-Ventil geschlossen ist. Die Elektrodenstruktur 5 ist dabei nicht erregt, d.h., das Piezoelement 2 ist inaktiv. Die hohe Eigensteifigkeit des Piezoelements führt dazu, dass das Ventil auch bei Gegendruck im Einlasskanal geschlossen bleibt. Fig. 15b stellt den Zustand dar, bei dem das Mikro-Ventil geöffnet ist. Die Elektrodenstruktur 5 ist in diesem Zustand erregt. Dabei ist es wichtig, dass die Auslenkung des Piezoelements 2 groß ist, um den Druckverlust des Ventils gering zu gestalten. Diese Auslenkung wird durch das Aufsatzelement 6, wie vorstehend erläutert, verbessert. Ein Vorteil dieser Anwendung ist unter anderem, dass die Elektroden nicht von der Flüssigkeit oder dem Gas berührt werden, während gleichzeitig bei einem einfachen Aufbau des Mikro-Ventils die Auslenkung desselben ausreichend ist, den Druckverlust gering zu halten.

Die Erfindung lässt neben den erläuterten Ausführungsformen weitere Gestaltungsgrundsätze zu. So können die Geometrien der verschiedenen Ausführungsformen auch beliebig miteinander kombiniert werden. Beispielsweise kann eine Elektrodenstruktur mit einer unregelmäßigen Außenkontur auch mit einer lückenhaften Umfassung kombiniert werden.

Obschon bei allen Ausführungsformen eine Elektrodenstruktur 5 für ein Piezoelement 2 angegeben ist, kann das Piezoelement 2 auch mehrere Elektrodenstrukturen 5 mit jeweils zugehörigen Aufsatzelementen 6 aufweisen. Beispielsweise kann ein einzelnes großflächiges Piezoelement 2 eine Mehrzahl von, z.B. vier oder zwölf, Elektrodenstrukturen 5 aufweisen, wobei dann jede Elektrodenstruktur 5 von zumindest einem Aufsatzelement 6 umgeben ist. Damit können mehrere Aktoren 1 aus einem einzelnen Piezoelement 2 hergestellt werden, während das Aufsatzelement 6 für eine kräftemäßige Trennung dieser Aktoren sorgt, obwohl sich diese ein gemeinsames Piezoelement 2 teilen.

### Bezugszeichenliste:

- 1: piezoelektrischer Aktor
- 2: Piezoelement
- 4: Auflage bzw. Ventilsitz
- 5: Elektrodenstruktur
- 6: Aufsatzelement
- 7: erste Kontaktierungsstelle
- 8: zweite Kontaktierungsstelle

## Patentansprüche

1. Piezoelektrischer Aktor (1), aufweisend:
ein Piezoelement (2); und
eine Elektrodenstruktur (5), aufweisend mindestens zwei Elektroden, wobei diese mit deren Elektroden ausschließlich auf einer Seite des Piezoelements (2) angeordnet ist; und
zumindest ein Aufsatzelement (6), aufweisend eine Innenkavität, wobei
das Aufsatzelement (6) auf dem Piezoelement (2) und auf der Seite der Elektrodenstruktur (5) des Piezoelements (2) angebracht ist, und
das Aufsatzelement (6) die Elektrodenstruktur (5) des piezoelektrischen Aktors (1) zumindest teilweise derart umfasst, dass die Innenkavität einen umfassten Bereich der Elektrodenstruktur (5) definiert, und wobei
das Aufsatzelement (6) ausschließlich in Kontakt mit dem Piezoelement (2) steht, und wobei
das Aufsatzelement (6) an die einseitig angebrachte Elektrodenstruktur (5) des piezoelektrischen Aktors (1) derart angepasst ist, dass das Aufsatzelement (6) eine Ausdehnung in der Ebene des Piezoelements (2) in die Richtungen begrenzt, in die sich das Piezoelement (2) aufgrund der Konfiguration der Elektrodenstruktur (5) überwiegend ausdehnt.

2. Piezoelektrischer Aktor (1) gemäß Anspruch 1, wobei
die Fläche der Elektrodenstruktur (5) um bis zu 30% kleiner oder größer ist, als die von dem Aufsatzelement (6) umfasste Fläche.

3. Piezoelektrischer Aktor (1) gemäß einem der Ansprüche 1 oder 2, wobei
wobei das Aufsatzelement (6) zumindest eine Aussparung oder Lücke aufweist.

4. Piezoelektrischer Aktor (1) gemäß einem der Ansprüche 1 bis 3, wobei
das Material des Piezoelements (2) Blei-Zirkonat-Titanat (PZT) ist.

## Claims

1. A piezoelectric actuator (1), comprising:
a piezoelectric element (2); and
an electrode structure (5), comprising at least two electrodes, wherein the latter with its electrodes is arranged exclusively on a side of the piezoelectric element (2); and
at least one top element (6), comprising an inner cavity, wherein
the top element (6) is attached onto the piezoelectric element (2) and on the side of the electrode structure (5) of the piezoelectric element (2), and
the top element (6) at least partially encompasses the electrode structure (5) of the piezoelectric actuator (1) such that the inner cavity defines an extensive area of said electrode structure (5), and wherein
the top element (6) is exclusively in contact with the piezoelectric element (2), and wherein
the top element (6) is adapted to the electrode structure (5) fitted on one side of the piezoelectric actuator (1) such that the top element (6) limits an expansion in the plane of the piezoelectric element (2) in the directions in which said piezoelectric element (2) essentially expands due to the configuration of the electrode structure (5).

2. The piezoelectric actuator (1) according to claim 1, wherein
the area of the electrode structure (5) is up to 30% smaller or larger than the area encompassed by the top element (6).

3. The piezoelectric actuator (1) according to one of claims 1 or 2, wherein
the top element (6) has at least one recess or gap.

4. The piezoelectric actuator (1) according to one of claims 1 through 3, wherein
the material of the piezoelectric element (2) is lead zirconate titanate (PZT).

## Revendications

1. Actionneur piézoélectrique (1), comportant :
- un élément piézoélectrique (2) ; et
- une structure d'électrodes (5), comportant au moins deux électrodes, laquelle structure d'électrodes est agencée avec ses électrodes exclusivement sur un côté de l'élément piézoélectrique (2) ; et
- au moins un élément chapeau (6), comportant une cavité interne, dans lequel
l'élément chapeau (6) est placé sur l'élément piézoélectrique (2) et sur le côté de la structure d'électrodes (5) de l'élément piézoélectrique (2), et
l'élément chapeau (6) entoure au moins en partie la structure d'électrodes (5) de l'actionneur piézoélectrique (1) de telle sorte que la cavité interne définit une zone entourée de la structure d'électrodes (5), et dans lequel
l'élément chapeau (6) est en contact exclusivement avec l'élément piézoélectrique (2), et dans lequel
l'élément chapeau (6) est adapté à la structure d'électrodes (5), placée d'un côté, de l'actionneur piézoélectrique (1) de telle sorte que l'élément chapeau (6) délimite une extension dans le plan de l'élément piézoélectrique (2) dans les directions dans lesquelles l'élément piézoélectrique (2) s'étend en majorité en raison de la configuration de la structure d'électrodes (5).

2. Actionneur piézoélectrique (1) selon la revendication 1, dans lequel
la surface de la structure d'électrodes (5) est jusqu'à 30 % plus petite ou plus grande que la surface entourée par l'élément chapeau (6).

3. Actionneur piézoélectrique (1) selon l'une quelconque des revendications 1 ou 2, dans lequel
dans lequel l'élément chapeau (6) comporte au moins un évidement ou vide.

4. Actionneur piézoélectrique (1) selon l'une quelconque des revendications 1 à 3, dans lequel
le matériau de l'élément piézoélectrique (2) est du titano-zirconate de plomb (PZT).
